# EUROPEAN PATENT APPLICATION

(11) **EP 4 459 303 A1**
(43) Date of publication of application: **06.11.2024**
(21) Application number: 23171281.1
(22) Date of filing: 03.05.2023
(51) Int. Cl.: G01R 31/40

(54) **POWER LOSS DETECTOR**

(71) Applicant: B/E Aerospace, Inc., Winston-Salem, NC 27105 (US)
(72) Inventor: DOUMA, Theodoor, 3905 LM Veenendaal (NL)
(74) Representative: Dehns

(57) **Abstract**

A power loss detector for an aircraft galley, the aircraft galley comprising a power supply and an aircraft galley load, the power supply configured to supply DC power to an aircraft galley load, the power loss detector comprising: a voltage sensor configured to determine an initial voltage of the power supply and a subsequent voltage of the power supply; and a controller configured to determine from the initial voltage and the subsequent voltage a voltage change, the controller configured to determine a power loss in the event that the voltage change exceeds a voltage change threshold.

## Description

### FIELD OF THE INVENTION

This application relates to a power loss detector, an aircraft galley power system, an aircraft galley, an aircraft and a method.

### BACKGROUND

Aircraft galleys require DC power to power aircraft galley loads (e.g. kitchen appliances). The voltage at which the DC power is provided may vary between different galleys and different loads, which can present difficulties in detecting power loss within a reasonable response time.

### SUMMARY

In a first aspect of the invention, there is provided a power loss detector for an aircraft galley, the aircraft galley comprising a power supply and an aircraft galley load, the power supply configured to supply DC power to an aircraft galley load, the power loss detector comprising: a voltage sensor configured to determine an initial voltage of the power supply and a subsequent voltage of the power supply; and a controller configured to determine from the initial voltage and the subsequent voltage a voltage change, the controller is configured to determine a power loss in the event that the voltage change exceeds a voltage change threshold.

Power loss may be more reliably and quickly detected by considering voltage change (e.g. in comparison to determining when the supply voltage reaches a fixed threshold), particularly in systems where supply voltage may change or where it may be desirable to use the same type of power loss detector in different systems with different supply voltages. Response time in determining power loss may also be improved in contrast to waiting until supply voltage reaches a fixed, often necessarily lower, threshold.

In an example, the voltage sensor is configured to measure an initial series of voltages of the power supply across an initial time period, wherein the voltage sensor is configured to determine the initial voltage from the initial series of voltages.

In an example, the voltage sensor is configured to determine the initial voltage as an average of the voltages of the initial series of voltages.

In an example, the initial time period has a duration of at least 1 second. In an example, the initial time period has a duration of at least 2 seconds. In an example, the initial time period has a duration of substantially 3 seconds.

In an example, the voltage sensor is configured to measure a single voltage of the power supply and determine the subsequent voltage as the single voltage. The single voltage may be a current voltage.

In an example, the voltage sensor is configured to measure a subsequent series of voltages of the power supply across a subsequent time period, wherein the voltage sensor is configured to determine the subsequent voltage from the subsequent series of voltages.

In an example, the voltage sensor is configured to determine the subsequent voltage as an average of the voltages of the subsequent series of voltages.

In an example, the subsequent time period has a duration of at least 1 second. In an example, the subsequent time period has a duration of at least 2 seconds. In an example, the subsequent time period has a duration of substantially 3 seconds.

In an example, the subsequent time period overlaps the earlier time period.

In an example, the subsequent time period is substantially equal in duration to the earlier time period.

In an example, the voltage change threshold is at least 5% of the initial voltage. In an example, the voltage change threshold is substantially 10% of the initial voltage.

In an example, the controller is configured to control a load of the aircraft galley to perform a graceful shutdown in response to the power loss event being determined.

According to a second aspect, there is provided an aircraft galley load comprising the power loss detector.

The aircraft galley load may comprise the power supply, the power supply configured to supply DC power to the aircraft galley load.

The aircraft galley load may be an appliance. The aircraft galley load may be a kitchen appliance.

According to a third aspect, there is provided an aircraft galley power system comprising the power loss detector and the power supply.

According to a fourth aspect, there is provided an aircraft galley comprising the aircraft galley load of the second aspect or the aircraft galley power supply of the third aspect.

According to a fifth aspect, there is provided an aircraft comprising the aircraft galley.

According to a sixth aspect, there is provided a method of detecting power loss of a power supply in an aircraft galley power system, the method comprising: determining an initial voltage of the power supply and a subsequent voltage of the power supply; determining from the initial voltage and the subsequent voltage a voltage change; and determine a power loss in the event that the voltage change exceeds a voltage change threshold.

Any of the aspects may comprise any of the features described with respect to any of the other aspects.

### BRIEF DESCRIPTION OF THE DRAWINGS

Various examples will now be described with reference to the accompanying drawings in which:
Figure 1 shows a schematic of an aircraft comprising an aircraft galley power system; and
Figure 2 shows a method of detecting power loss;
Figure 3 shows a schematic of an aircraft comprising an aircraft galley load.

### DETAILED DESCRIPTION

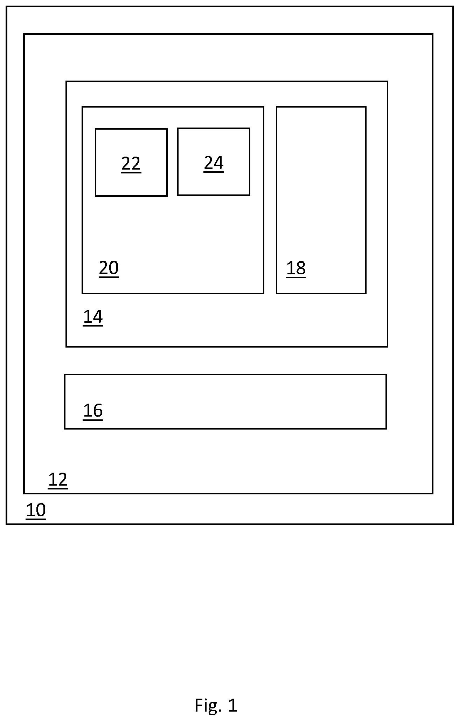

Fig. 1 shows an aircraft 10. The aircraft 10 comprises an aircraft galley 12. The aircraft galley 12 comprises an aircraft galley power system 14 and an aircraft galley load 16. The aircraft galley power system 14 is configured to supply power to the aircraft galley load 16, which may comprise, for example, kitchen appliances (e.g. a beverage maker, a refrigerator and a microwave) and/or communication devices. The communication devices may be comprised in the appliances. The aircraft galley load 16 may comprise a plurality of such appliances and/or devices, with the aircraft galley power system 14 being configured to apply to all appliances and/or devices.

The aircraft galley power system 14 comprises a power supply 18 and a power loss detector 20. The power loss detector 20 comprises a voltage sensor 22 and a controller 24.

The power supply 18 is configured to receive power from a power source (e.g. from an energy storage such as a battery or from an aircraft engine) and to supply the power to the aircraft galley loads 16. The power supply 18 is configured to supply low voltage DC power to the aircraft galley loads 16. The power supply 18 may comprise DC-DC converters and/or rectifiers, or may receive already converted and/or rectified power, simply passing the power onto the aircraft galley loads 16.

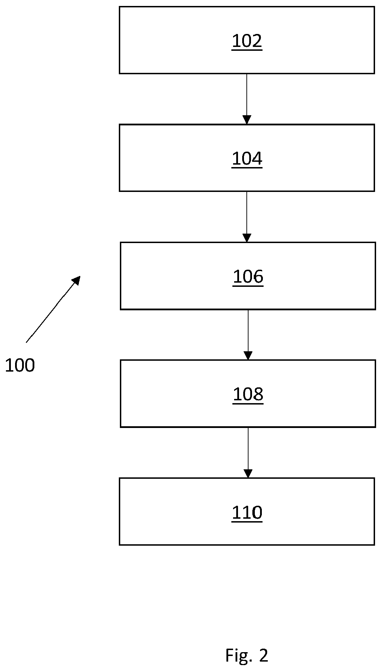

Fig. 2 shows a method 100 of power loss detection, which is performed by the aircraft galley power system 14. The method 100 comprises an initial voltage determination step 102, a subsequent voltage determination step 104, a voltage change determination step 106, a voltage change comparison step 108 and a response step 110.

During the method 100, the power supply 18 supplies direct current (DC) power to the aircraft galley load 16 until power loss of the power supply 8 occurs. To supply the DC power, the power supply 8 applies a voltage across terminals (not shown) of the aircraft galley load 16.

In the initial voltage determination step 102, the voltage sensor 22 determines an initial voltage of the power supply 8. In the present example, the voltage sensor measures an initial series of voltages. The initial series of voltages comprises a plurality of voltages of the power supply 8 measured over time, for example, with a constant time period between the voltages.

The voltage sensor 22 measures the initial series of voltages over a time period, referred to as an initial time period. The initial time period has a duration of substantially 3 seconds.

The voltage sensor 22 determines the initial voltage from the initial series of voltages as an average (in the present example, an arithmetic mean) of the voltages of the initial series of voltages. In other examples, the voltage sensor 22 may determine the initial voltage as the average of the initial series of voltages in another manner, for example, as a weighted average or as a median value. In other examples, the voltage sensor 22 may measure only one voltage value to determine the initial voltage, with the initial voltage being determined as the one voltage value.

In the subsequent voltage determination step 104, the voltage sensor 22 determines a subsequent voltage of the power supply 8. In the present example, the voltage sensor measures a subsequent series of voltages. The subsequent series of voltages comprises a plurality of voltages of the power supply 8 measured over time, for example, with a constant time period between the voltages.

The voltage sensor 22 measures the subsequent series of voltages over a time period, referred to as a subsequent time period. The subsequent time period has a duration of substantially 3 seconds. The subsequent time period has the same duration as the initial time period.

Herein the terms "initial" and "subsequent" in relation to voltages and time periods are used to indicate those which occur generally earlier or later in time, such that initial voltages/time periods occur at generally earlier times than subsequent voltages/time periods.

The term "initial" is intended to indicate initial in relation to the method 100 (e.g. occurring at the beginning of the method 100), rather than, for example, the absolute initial or first voltages measured on activation of the power supply. It will be understood that the method 100 may be performed on several occasions during activation of the power supply (e.g. periodically), with the initial time period generally occurring later in time for each next occasion that takes place.

In the present example, the subsequent time period and the initial time period overlap. A selection of the voltages of the initial series of voltages are also in the subsequent series of voltages. The subsequent time period begins after the initial time period begins. The subsequent time period ends after the initial time period ends.

The voltage sensor 22 determines the subsequent voltage from the subsequent series of voltages as an average (in the present example, an arithmetic mean) of the voltages of the subsequent series of voltages. In other examples, the voltage sensor 22 may determine the subsequent voltage as the average of the subsequent series of voltages in another manner, for example, as a weighted average or as a median value.

In other examples, the voltage sensor 22 may measure only one voltage value (a single voltage, e.g. a current voltage, which may also be referred to as a realtime voltage) to determine the subsequent voltage, with the subsequent voltage being determined as the one voltage value. In such examples, the voltage sensor may still be configured to determine the initial voltage from the initial series of voltages. The subsequent voltage may be measured shortly after the end of the initial time period (e.g. the first voltage measured after the end of the initial time period or a voltage measured a fixed interval after the end of the initial time period) or may be measured during the initial time period (e.g. the final voltage measured in the time period).

In the voltage change determination step 106, the controller 24 determines a voltage change from the initial voltage and the subsequent voltage. In the present example, the controller 24 determines the voltage change as the difference between the initial voltage and the subsequent voltage. In the other examples, the voltage change may be determined differently, for example as a rate of change of voltage over time.

In the voltage change comparison step 108, the controller 24 compares the voltage change to a voltage change threshold. The controller 24 determines that a power loss has occurred in the event that the voltage change exceeds the voltage change threshold.

In the present example, the voltage change threshold is variable and is a proportion of the initial voltage. The voltage change threshold is 10% of the initial voltage. In other examples, the voltage change threshold may be a fixed value regardless of the initial voltage.

In the event that the power loss has occurred, the controller 24 takes an action in the response step 110. The action may comprise controlling the aircraft galley load 16 (or a component thereof) to perform a graceful shutdown or transmitting a shutdown signal to the aircraft galley load 16 to cause the aircraft galley load 16 to perform the graceful shutdown.

As mentioned above, the method 100 occurs multiple times, particularly in the event that power loss does not occur. The method 100 may take place regularly e.g. periodically.

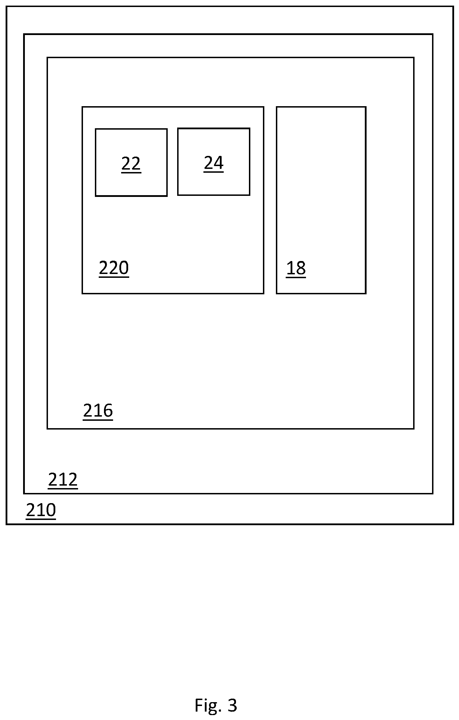

Fig. 3 shows a second aircraft 210 comprising a second aircraft galley 212. The second aircraft galley 212 comprises a second aircraft galley load 216, which as for the aircraft galley load 16, may be a kitchen appliance and/or a communication device. The second aircraft galley 212 may comprise a plurality of such second aircraft galley loads 216.

In contrast to in the aircraft galley 12, the second aircraft galley 212 does not comprise a separate aircraft galley power system as described above, with the second aircraft galley 212 itself comprising the power supply 18 and the power loss detector 20.

The power supply 18 supplies power for the second aircraft galley load 16. The power supply receives power from the power source as before. In the second aircraft galley 212, the power loss detector 20 operates in the same manner as the aircraft galley 12, performing the method 100. Repeated description of that operation is omitted.

While particular functional steps have been described with respect to the voltage sensor 22 and the controller 24, it is possible that some functional steps could be performed with the other of the voltage sensor and the controller. Additionally, some functional steps may be performed in a different processor, for example, a remotely located processor. Analogue or digital circuitry may also be used in place of a processor

Various aspects of the apparatus disclosed in the various embodiments may be used alone, in combination, or in a variety of arrangements not specifically discussed in the embodiments described in the foregoing and this disclosure is therefore not limited in its application to the details and arrangement of components set forth in the foregoing description or illustrated in the drawings. For example, aspects described in one embodiment may be combined in any manner with aspects described in other embodiments. Although particular embodiments have been shown and described, it will be obvious to those skilled in the art that changes and modifications may be made without departing from this invention in its broader aspects. The scope of the following claims should not be limited by the embodiments set forth in the examples, but should be given the broadest reasonable interpretation consistent with the description as a whole.

## Claims

1. A power loss detector for an aircraft galley, the aircraft galley comprising a power supply and an aircraft galley load, the power supply configured to supply DC power to an aircraft galley load, the power loss detector comprising:
a voltage sensor configured to determine an initial voltage of the power supply and a subsequent voltage of the power supply; and
a controller configured to determine from the initial voltage and the subsequent voltage a voltage change, the controller configured to determine a power loss in the event that the voltage change exceeds a voltage change threshold.

2. A power loss detector according to claim 1, wherein the voltage sensor is configured to measure an initial series of voltages of the power supply across an initial time period, wherein the voltage sensor is configured to determine the initial voltage from the initial series of voltages.

3. A power loss detector according to claim 2, wherein the voltage sensor is configured to determine the initial voltage as an average of the voltages of the initial series of voltages.

4. A power loss detector according to claim 2 or 3, wherein the initial time period has a duration of at least 1 second.

5. A power loss detector according to any preceding claim, wherein the voltage sensor is configured to measure a single voltage of the power supply and determine the subsequent voltage as the single voltage.

6. A power loss detector according to any preceding claim, wherein the voltage change threshold is a proportion of the initial voltage.

7. A power loss detector according to any preceding claim, wherein the controller is configured to control a load of the aircraft galley to perform a graceful shutdown in response to the power loss event being determined.

8. An aircraft galley load comprising the power loss detector according to any preceding claim.

9. An aircraft galley load according to claim 8 and comprising the power supply, the power supply configured to supply DC power to the aircraft galley load.

10. An aircraft galley load according to claim 8 or 9, wherein the aircraft galley load is a kitchen appliance.

11. An aircraft galley power system comprising the power loss detector according to any of claims 1 to 7 and the power supply, the power supply configured to supply DC power to the aircraft galley load.

12. An aircraft galley comprising an aircraft galley load according to any of claims 8-10 or an aircraft galley power system according to claim 11.

13. An aircraft comprising the aircraft galley of claim 12.

14. A method detecting power loss of a power supply in an aircraft galley power system, the method comprising:
determining an initial voltage of the power supply and a subsequent voltage of the power supply;
determining from the initial voltage and the subsequent voltage a voltage change;and
determine a power loss in the event that the voltage change exceeds a voltage change threshold.
